# EUROPEAN PATENT APPLICATION

(11) **EP 1 035 581 A2**
(43) Date of publication of application: **13.09.2000**
(21) Application number: 00301836.3
(22) Date of filing: 07.03.2000
(51) Int. Cl.: H01L 23/498, H01L 23/538, H05K 1/02

(54) **Multilayer wiring board**

(30) Priority: 10.03.1999 JP 6261999
(71) Applicant: SHINKO ELECTRIC INDUSTRIES CO. LTD., Nagano-shi, Nagano 380-0921 (JP)
(72) Inventor: Ohi, Masayuki, c/o Shinko Electric Ind. Co., Ltd., Nagano-shi, Nagano 380-0921 (JP); Imai, Kunihiko, c/o Shinko Electric Ind. Co., Ltd., Nagano-shi, Nagano 380-0921 (JP)
(74) Representative: Rackham, Stephen Neil

(57) **Abstract**

A multilayer wiring board (50) including a core board which comprises a resin baseplate (10) outer wiring patterns (12) on one and the other sides of the core board (10), respectively, and throughholes (44) penetrating the core board and having a side wall coated with a conductive material (46) electrically connecting the outer wiring patterns with each other, wherein a space within the throughholes is filled with a filler material (48) having a thermal expansion coefficient substantially equal to that of the resin baseplate (10).

## Description

The present invention relates to a multilayer wiring board and a process of producing the same and, particularly, to a multilayer wiring board having multiple wiring layers formed on a core board by a build-up method and a process of producing the same.

A multilayer wiring board is conventionally produced by forming multiple wiring layers on a core board, including a resin baseplate, in which the core board usually includes four conductive layers.

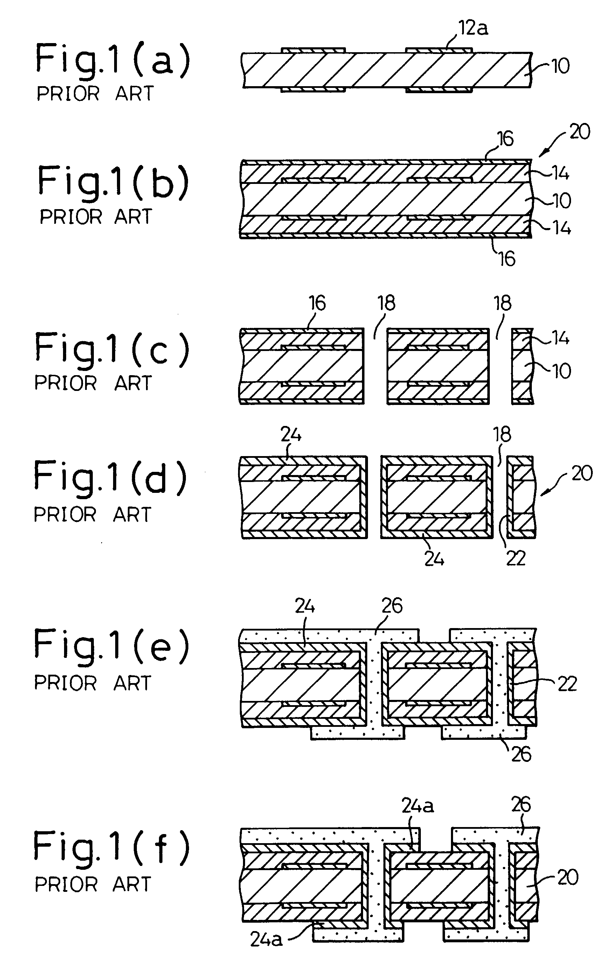

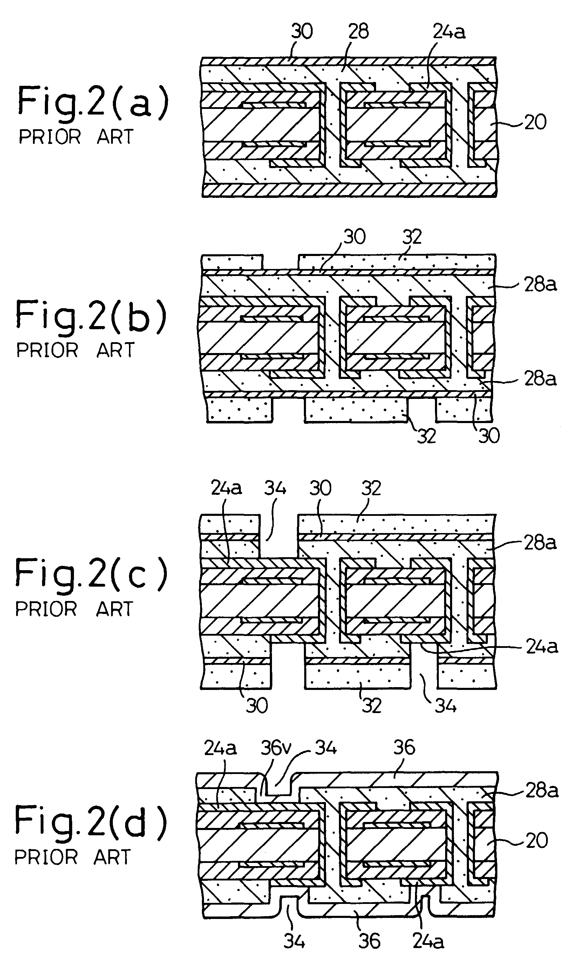

Figures 1(a) to 1(f) and 2(a) to 2(d) show the conventional process steps for producing a multilayer wiring board using a core board.

Figure 1(a) shows a structure of a resin baseplate 10 of glass-epoxy or the like originally having on both sides a conductive layer of copper foil or the like which is etched to form a base wiring pattern 12a. A prepreg is then pressed onto the structure and heated and a conductive layer 16 is deposited thereon to form a core board 20 having four conductive layers 16, 12a, 12a and 16, as shown in Fig. 1(b).

The core board 20 is then subject to boring to form throughholes 18 penetrating the core board 20 in the thickness direction of the core board 20 as shown in Fig. 1(c) and, as shown in Fig. 1(d), electroless and electrolytic plating treatments are conducted to form a conductive layer composed of one portion 22 coating the side wall of the throughholes 18 and the other portion covering the conductive layer 16 to form a thicker conductive layer 24, in which the conductive layers 24 on both sides of the core board 20 are electrically connected with each other through the conductive layer 22 on the side wall of the throughholes 18.

The conductive layer 24 is then patterned by etching to form a desired wiring pattern. This is effected by forming a resist pattern 26 shown in Fig. 1(e) and, as shown in Fig. 1(f), etching the conductive layer 24 by using the resist pattern 26 as an etching mask to form a desired wiring pattern 24a. The core board 20 is completed by removing the resist pattern 26.

Further wiring patterns, with intervening insulating layers therebetween, are formed on both sides of the core board 20, as shown in Figs. 2(a) to 2(d).

An insulating film 28 having a conductive layer 30 of a copper foil or the like on one side thereof is laminated on the surface of the core board 20 (Fig. 2(a)), a resist pattern 32 is formed on the conductive layer 30 (Fig. 2(b)), and a viahole 34 is then formed by etching the conductive layer 30 using the resist pattern as an etching mask and further etching or laser-machining the insulating layer 28a to expose the wiring pattern 24, the viahole 34 having a bottom defined by the exposed surface of the wiring pattern 24 (Fig. 2(c)). The resist pattern 32 is then removed and electroless and electrolytic plating treatments are carried out to form a conductive layer covering the side wall of the viahole 34 and the conductive layer 30, one portion of which conductive layer, together with the underlying conductive layer 30, forms a thicker conductive layer 36 and the other portion forms a conductive coating or via 36v on the side wall the viahole 34 (Fig. 2(d)). The conductive layer 36 is then patterned by etching to form a further wiring pattern on the insulating layer 28a and electrically connected to the underlying wiring pattern 24a through the via 36v penetrating the insulating layer 28a.

To form more wiring patterns with intervening insulating layers, the same process steps as described above are repeated by laminating an insulating film having a conductive layer thereon, etching the conductive layer and further etching or laser-machining the insulating film or layer to form viaholes extending through the insulating layer and the conductive layer, forming vias by plating treatments of the viaholes for electrical connection between conductive layers, and patterning the conductive layer to form a wiring pattern.

The process of forming multiple wiring layers may be modified such that an insulating layer is formed by application of an insulating material instead of lamination of an insulating film, or that a via is formed by sputtering instead of electroless and electrolytic plating treatments.

As described above, the conventional process produces a multiple wiring board by forming multiple wiring layers on a core board, which is formed from a resin baseplate and has four wiring layers.

The conventional process has a problem in that the multilayer wiring board may be distorted by thermal stress occurring during mounting of a semiconductor chip thereon, that the core board cannot be thin because of the use of a prepreg for an insulating layer and that the process is complicated and costs much because it requires pressing and heating the prepreg.

The object of the present invention is to provide a multilayer wiring board and a process of producing the same which enables the distortion to be prevented from occurring during mounting of a semiconductor chip thereon, the production cost to be reduced, the thickness of a core board to be reduced and, further, the wiring density to be increased.

To achieve the object according to the present invention, there is provided a multilayer wiring board including a core board which comprises a resin baseplate, outer wiring patterns on one and the other sides of the core board, respectively, and throughholes penetrating the core board and having a side wall coated with a conductive material electrically connecting the outer wiring patterns with each other, wherein a space within the throughholes is filled with a filler material having a thermal expansion coefficient substantially equal to that of the resin of the resin baseplate.

In a typical embodiment of the multilayer wiring board according to the present invention, the core board comprises the resin baseplate having both sides on each of which are provided a base wiring pattern, a first insulating layer and the outer wiring pattern in that order.

In a preferred embodiment of the multilayer wiring board according to the present invention, a further insulating layer and a further wiring pattern are provided on the outer wiring pattern in that order for both sides of the core board, the filler material has a conductor member provided on at least one end thereof and electrically connected to the conductive material on the side wall of the throughholes, and a further conductive material extending through the further insulating layer at the position of the conductor member to electrically connect the further wiring pattern and the outer wiring pattern of the core board.

In another preferred embodiment, the filler material has a concave end.

The present invention also provides a process of producing a multilayer wiring board, comprising the steps of:
preparing a resin baseplate having a base wiring pattern on both sides;
forming a first insulating layer on both sides of the resin baseplate to cover the base wiring pattern;
forming a throughhole penetrating the resin baseplate having the first insulating layers on both sides thereof;
forming a conductive layer which covers the first insulating layer, for both sides of the resin baseplate, and coats a side wall of the throughhole;
filling a space within the throughhole with a filler material having a thermal coefficient substantially equal to that of the resin of the resin baseplate;
flattening, for both sides of the resin baseplate, an end of the filler material protruding from the throughhole and a free surface of the conductive layer so that the end of the filler material and the free surface of the conductive layer are flush with each other;
etching, for both sides of the resin baseplate, the conductive layer to form a second wiring pattern on the first insulating layer;
forming, for both sides of the resin baseplate, a second insulating layer which covers the second wiring pattern; and
forming, for both sides of the resin baseplate, a third wiring pattern on the second insulating layer.

The present invention further provides a process of producing a multilayer wiring board, comprising the steps of:
preparing a resin baseplate having a first wiring pattern on both sides;
forming a first insulating layer on both sides of the resin baseplate to cover the first wiring pattern;
forming a throughhole penetrating the resin baseplate having the insulating layers on both sides thereof;
forming a first conductive layer which covers the first insulating layer, for both sides of the resin baseplate, and coats a side wall of the throughhole;
filling a space within the throughhole with a filler material having a thermal coefficient substantially equal to that of the resin of the resin baseplate;
flattening, for both sides of the resin baseplate, an end of the filler material protruding from the throughhole and a free surface of the first conductive layer so that the end of the filler material and the free surface of the first conductive layer are flush with each other;
forming, for both sides of the resin baseplate, a second conductive layer on the first conductive layer and the end of the filler material, the first and second conductive layers forming a single conductive layer;
etching, for both sides of the resin baseplate, the single conductive layer to form a second wiring pattern on the first insulating layer;
forming, for both sides of the resin baseplate, a second insulating layer which covers the second wiring pattern; and
forming, for both sides of the resin baseplate, a third wiring pattern on the second insulating layer.

The step of flattening may be modified so that the end of the filler material is concaved and the free surface of the first conductive layer is flattened.

In a typical embodiment of the process according to the present invention, the first and second insulating layers are formed by laminating an insulating film.

### BRIEF DESCRIPTION OF THE DRAWINGS

Figures 1(a) to 1(f) show the conventional process steps for producing a multilayer wiring board using a core board, in cross-sectional views;
Figs. 2(a) to 2(d) show the conventional process steps for forming further wiring layers on the core board, in cross-sectional views;
Figs. 3(a) to 3(h) show the process steps of producing a core board having four conductive layers according to the present invention, in cross-sectional views;
Figs. 4(a) to 4(d) show the process steps of forming further wiring layers on the core board according to the present invention, in cross-sectional views;
Fig. 5 shows a multilayer wiring board produced on the structure shown in Fig. 4(d) by a further process step according to the present invention, in a cross-sectional view;
Figs. 6(a) to 6(f) show another preferred embodiment of the process of producing a multilayer wiring board according to the present invention, in cross-sectional views;
Fig. 7 shows a multilayer wiring board produced by the process steps shown in Figs. 6(a) to 6(f), in a cross-sectional view; and
Fig. 8 shows further preferred embodiment of the present invention, in a cross-sectional view.

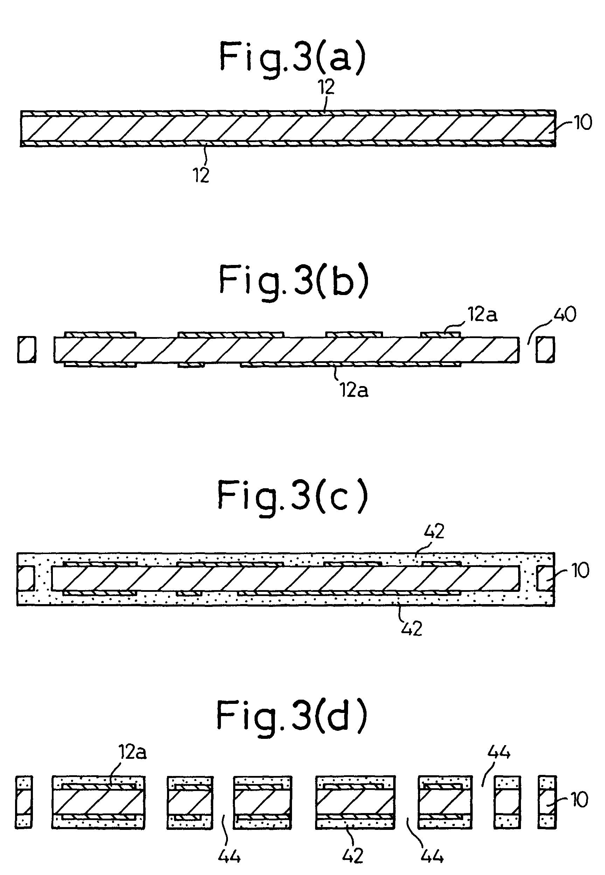

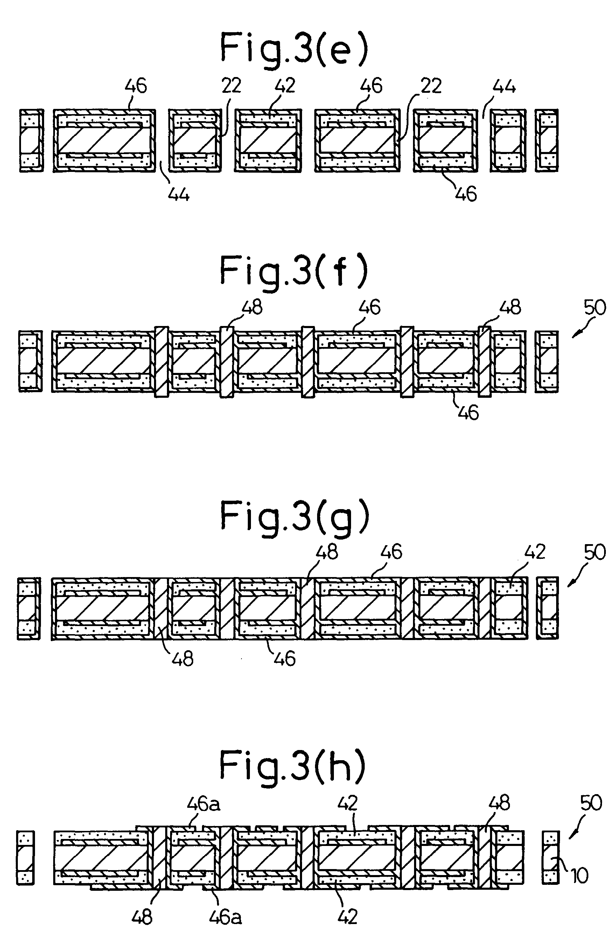

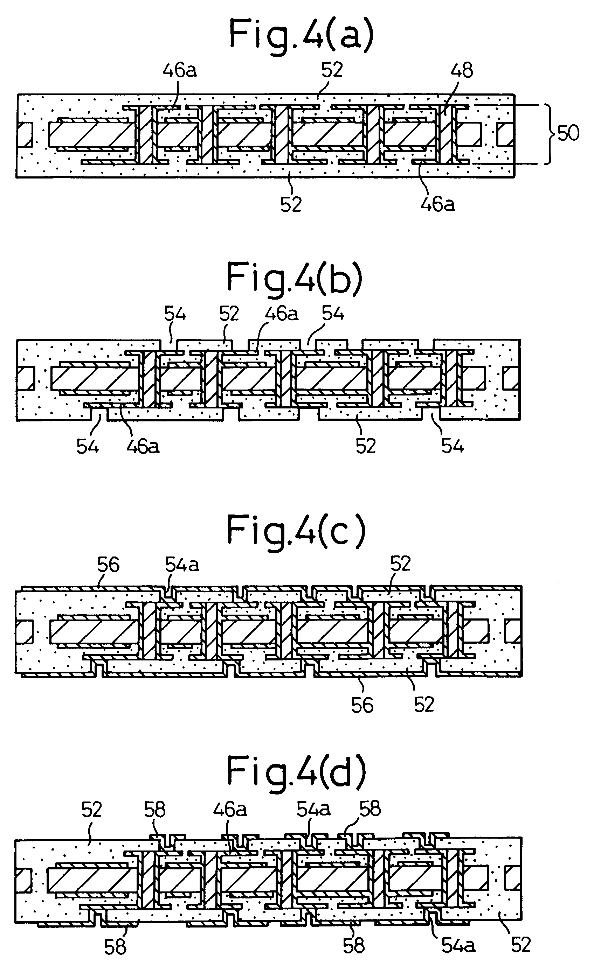

Referring to Figs. 3(a) to 3(h) and 4(a) to 4(d), the process steps of producing a multilayer wiring board according to a preferred embodiment of the present invention will be described.

Figures 3(a) to 3(h) show the process steps of producing a core board having four conductive layers and Figs. 4(a) to 4(d) show the process steps of forming further wiring layers on the core board.

Figure 3(a) shows a resin baseplate 10 which provides a base of a core board. The resin baseplate 10 is produced by forming a conductive layer 12 of a copper foil on both sides of a resin plate composed of a resin impregnated in a fabric or a nonwoven fabric of epoxy or the like. The resin baseplate 10 has a thickness of 0.8 mm, for example. Various material and thicknesses of the resin baseplate 10 can be adopted.

Figure 3(b) shows holes 40 bored through the resin baseplate 10 for positioning and transfer and base wiring patterns 12a formed by etching the conductive layer 12 on both sides of the baseplate 10.

Figure 3(c) shows the next step, in which an insulating film of polyimide or other resin is laminated on both sides of the resin baseplate 10 to form an insulating layer 42 covering the wiring pattern 12a and the free surface of the resin baseplate 10. The insulating layer 42 may otherwise be formed by coating an insulating resin material on the resin base plate 10 instead of by lamination of an insulating film. The insulating layer 42 has a thickness of several tens of micrometers.

Figure 3(d) shows throughholes 44 formed through the resin baseplate 10 and the insulating layer 42 by drilling or laser-machining at positions for electrical connection between wiring layers on both sides of the resin baseplate 10.

Figure 3(e) shows the next step, in which the insulating layer 42 is surface-roughened or grained and, then, electroless and electrolytic copper plating treatments are conducted to form a conductive coating 22 on the side wall of the throughholes 44 and, at the same time, a conductive layer 46 on the insulating layer 42. The electroless-plated copper deposit provides a current supply layer for the electrolytic copper plating. The surface-roughening or graining of the insulating layer 42 is effected by mechanical working and/or chemical treatment to improve a bond between the conductive layer 46 and the insulating layer 42. The conductive coating 22 and the conductive layer 46 may otherwise be formed by direct plating or other methods without using electroless plating.

Figure 3(f) shows an advantageous process step of the present invention, in which, after the conductive coating 22 and the conductive layer 46 are formed, a space within the throughholes 44 is filled with a filler material 48 having a thermal expansion coefficient substantially equal to that of the resin of the resin baseplate 10. This equalizes the thermal expansion coefficient over the resin baseplate 10 to prevent generation of thermal stress within the resin baseplate 10, particularly distortion which would otherwise occur during heating for mounting a semiconductor chip on a multilayer wiring board. The filler material may be either an insulating material such as resin or a conductive material such as a resin containing metal particles, in which the resin in the cured state must have a thermal expansion coefficient substantially equal to that of the resin of the resin baseplate 10.

The filler material can be filled in each of the throughholes 44 by screen printing. As shown in Fig. 3(f), the filler material 48 thus filled in the throughholes 44 has both ends slightly protruding from the surface of the conductive layer 46.

Referring to Fig. 3(g), the protruded ends of the filler material 48 are mechanically ground or flattened so that the filler material 48 has both ends flush with the surface of the conductive layer 46. During the flattening, the conductive layer 46 is also slightly ground to have a reduced thickness.

Figure 3(h) shows a core board 50 having, on both sides, a wiring pattern 46a formed by etching the conductive layer 46 to a desired pattern. This can be effected, for example, by applying a photosensitive resist on the conductive layer 46, which is then exposed to light and developed to form a resist pattern of the desired pattern, followed by chemical etching of the conductive layer 46 using the resist pattern as an etching mask.

In this embodiment, the core board 50 has the insulating layer 42 formed by lamination of an insulating film, the wiring layer 46a formed on the insulating layer 42, and the throughholes 44 electrically connecting wiring patterns on both sides of the core board 50, the space within the throughholes is filled with the filler material 48 having a thermal expansion coefficient substantially equal to that of the resin of the resin baseplate 10.

The present inventive core board 50 is advantageous over the conventional core board having four wiring layers in which an insulating layer is formed by pressing and heating a prepreg and a conductive layer formed by deposition on the insulating layer (Figs. 1(b)).

Specifically, the core board 50 has an insulating layer 42 which is formed by lamination of an insulating film and, therefore, the insulating layer 42 can be thinner than that of the conventional core board. Moreover, lamination of an insulating film is much easier than the conventional process of forming an insulating layer by pressing and heating of a prepreg followed by deposition of a conductive layer, and therefore, the production cost can be reduced. It is most advantageous that the present inventive core board 50 has throughholes 44 filled with a filler material 48 having a thermal expansion coefficient substantially equal to that of the resin of the resin baseplate 10 to prevent thermal stress from occurring during mounting a semiconductor chip on the core board.

Further wiring layers with intervening insulating layers therebetween are formed in the conventional manner.

Specifically, referring to Figs. 4(a) to 4(d), an insulating film is laminated on both sides of the core board 50 (Fig. 4(a)), the wiring pattern 46 is covered with an insulating layer 52 (Fig. 4(b)), electroless and electrolytic plating treatments are conducted to form a conductive layer 56 on the side wall of the viaholes 54 and on the insulating layer 52 (Fig. 4(c)), and the conductive layer 56 is patterned by etching to form a wiring pattern 58 (Fig. 4(d)). The viaholes 54 are formed by irradiating laser onto the insulating layer 52 until the wiring pattern 46a is exposed. The viaholes 54 may otherwise be formed by chemical etching. Vias 54a are formed on the side wall of the viaholes 54.

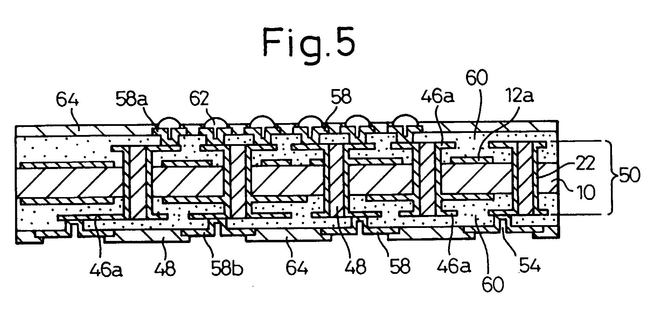

Figure 5 shows a multilayer wiring board produced on the structure shown in Fig. 4(d) by a further process step. A resin baseplate 10 provides a base on both sides of which a base wiring pattern 12a is formed and an intermediate wiring pattern 46a and an uppermost wiring pattern 58 are formed with an insulating layer 60 intervening therebetween. The shown multilayer wiring board is suitably used in a manner such that a semiconductor chip is mounted on the upper surface by flip chip bonding and lead pins are bonded to the lower surface of the board for mounting on a mother board. Figure 5 also shows lands 58a on which bumps 62 are formed for bonding a semiconductor chip and lands 58b to which lead pins and solder balls are bonded to provide external connection terminals. The surface of the lands 58a and 59a are plated with nickel, gold, etc., for protection. A solder resist or other coating 64 protects the surface of the multilayer wiring board, in which the protection coating 64 entirely covers the surface of the multilayer wiring board except for the portions in which lands 58a and 58b are formed.

The shown multilayer wiring board is thermally stable because the core board 50 has throughholes filled with a filler material having a thermal expansion coefficient substantially the same as that of the resin of the resin baseplate 10.

The multilayer wiring board may have various configurations other than that adapted for flip chip bonding of a semiconductor chip as described above and may have further wiring layers with insulating layers intervening therebetween, which is effected by forming further insulating layers 42 and further conductive layers 46a on the core board 50.

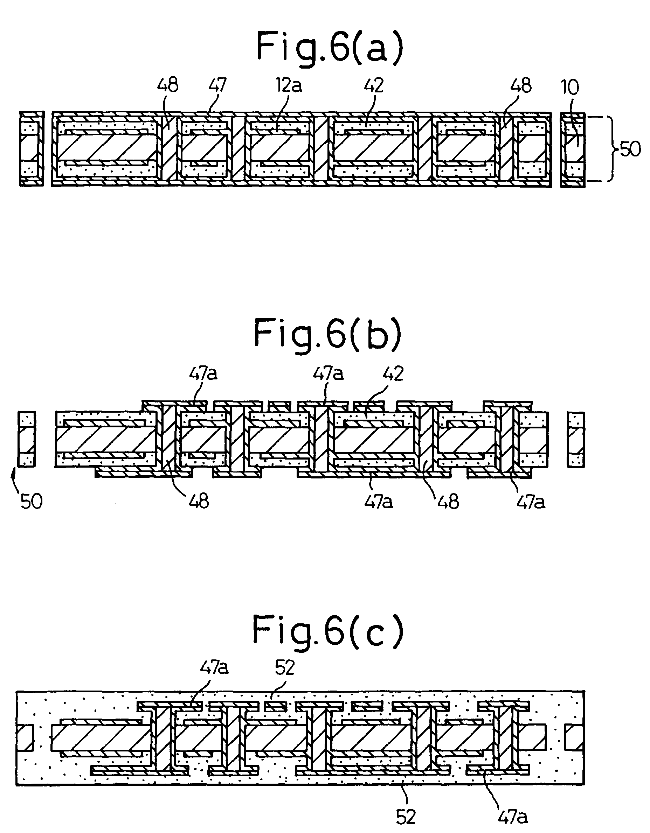

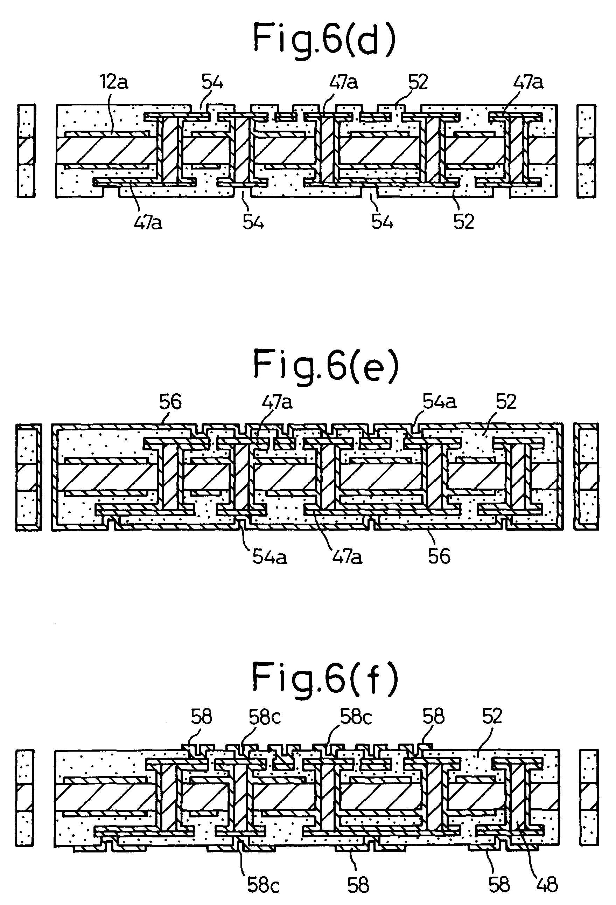

Figures 6(a) to 6(f) show another preferred embodiment of the process of producing a multilayer wiring board according to the present invention. In this embodiment, a filler material 48 filling the space of the throughholes 44 has a conductor member on at least one end.

The process steps shown in Figs. 3(a) to 3(g) are carried in the same manner as described above, except that the step of Fig. 3(g) is modified to further include, after flattening or making flush the end of the filler material 48 and the surface of the conductive layer 46, roughening the end of the filler material 48, followed by electroless and electrolytic copper plating treatments of the roughened end (Fig. 6(a)). This causes the surface of the core board 50, including the end of the filler material 48, to be covered with a conductive layer 47, which is thicker in the portions in which the conductive layer 46 is present than the other portion.

Figure 6(b) shows a wiring pattern 47a formed by etching the conductive layer 47 on the core board 50. The core board 50 of this embodiment is common to the core board 50 of the former embodiment in that the resin baseplate 10 has the same structure, throughholes 44 are filled with a filler material 48 and a wiring pattern 47a is formed on an insulating layer 42 and has a further feature that patterning of the conductive layer 47 by etching can simultaneously provide a conductor member 47a on the end of the filler material 48.

Figures 6(c) to 6(f) show the subsequent process steps to form further wiring layers with intervening insulating layers therebetween, including treatments basically the same as those conducted in the process steps of Figs. 4(a) to 4(d).

Specifically, Fig. 6(c) shows an insulating layer 52 formed by laminating an insulating film on both sides of the core board 50, Fig. 6(d) shows viaholes 54 formed in the insulating layer 52 by irradiation of laser beam, Fig. 6(e) shows a conductive layer 56 formed by electroless and electrolytic plating treatments, and Fig. 6(f) shows an wiring pattern 58 formed patterning the conductive layer 56 by etching. A conductive coating 54a is formed on the side wall of the viaholes 54 to provide a via.

As can be best seen from Figs. 6(d) to 6(f), this embodiment has an advantageous feature that the vias 54a can be disposed at the positions of the throughholes 44 because the filler material filling the throughholes 44 has both ends provided with the conductor member 47a. Figure 6(f) shows wiring patterns 58c disposed in alignment with the throughholes 44.

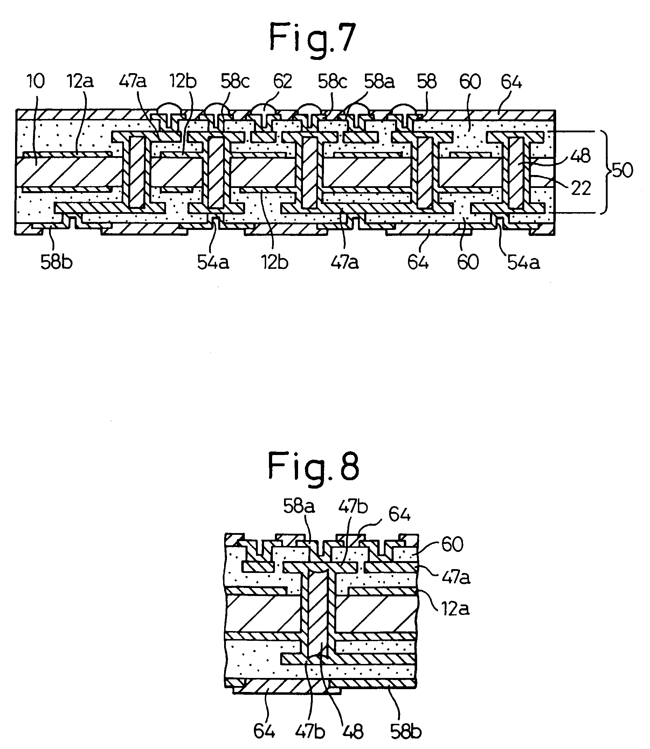

Figure 7 shows a multilayer wiring board produced by the above-described process steps. Wiring patterns 12a, 47a and 58a are laminated with intervening insulation layers forming a continuous insulating phase 60 and each pair thereof on both sides of the resin baseplate 10 are electrically connected to each other through the vias 22 and 54a. Lands 58a are bonded to pads for mounting a semiconductor chip and lands 58b are connected to lead pins. In the shown structure, the lands 58a are bonded to pads 62. Lands 58c are disposed in alignment with the throughholes 44.

According to the process of this embodiment, vias can be formed at any desired positions irrespective of the throughholes 44 provided in the core board 50. This increases the degree of freedom of designing wiring patterns and vias and facilitates designing the wiring board. The total length of wiring patterns can be reduced to provide improved electrical property and vias can be also disposed in an increased density.

In Fig. 7, the base wiring pattern 12b is designed to provide a common plane for power supply or ground. The structure of this embodiment is designed to dispose the vias 54a directly on the vias 22 provided at the throughholes 44, so that the lands 58c and the power supply plane 12b can be connected in the minimum distance.

Figure 8 shows another preferred embodiment of the present invention, in which a filler material 48 filling throughholes 44 has a concave end to mitigate thermal stress acting upon a conductor member 47b provided thereon, when thermal stress can be generated by a small difference in thermal expansion coefficient between the resin baseplate 10 and the filler material 48 and between the filler material 48 and the insulating film 42 laminated on both sides of the resin baseplate 10 during preparation of the core board 50. The thermal stress would otherwise be concentrated around the end of the filler material 48 to cause cracking to occur around the end and/or disconnection of the vias 54a from the conductor member 47b. The concave end of the filler material 48 of this embodiment prevents these problems from occurring.

The concave end of the filler material 48 can be provided by modifying the process step of Fig. 3(g), i.e., flattening or flushing the end of the filler material 48 with the surface of the conductor layer 46, so that the step includes grinding, shot blasting or chemically etching the end of the filler material 48.

The concave end of the filler material 48 disperses the thermal stress acting on the conductor member 47b and prevents cracking from occurring at the conductor member 47b.

As described herein above, the present invention provides a multilayer wiring board and a process of producing the same which enables the distortion to be prevented from occurring during mounting of a semiconductor chip thereon, the production cost to be reduced, the thickness of a core board to be reduced and, further, the wiring density to be increased.

## Claims

1. A multilayer wiring board including a core board which comprises a resin baseplate, outer wiring patterns on one and the other sides of the core board, respectively, and throughholes penetrating the core board and having a side wall coated with a conductive material electrically connecting the outer wiring patterns with each other, wherein a space within the throughholes is filled with a filler material having a thermal expansion coefficient substantially equal to that of the resin baseplate.

2. A multilayer wiring board according to claim 1, wherein the core board comprises the resin baseplate having both sides on each of which are provided a base wiring pattern, a first insulating layer and the outer wiring pattern in that order.

3. A multilayer wiring board according to claim 2, wherein a further insulating layer and a further wiring pattern are provided on the outer wiring pattern in that order for both sides of the core board, the filler material has a conductor member provided on at least one end thereof and electrically connected to the conductive material on the side wall of the throughholes, and a further conductive material extending through the further insulating layer at the position of the conductor member to electrically connect the further wiring pattern and the outer wiring pattern of the core board.

4. A multilayer wiring board according to claim 2 or 3, wherein the filler material has a concave end.

5. A process of producing a multilayer wiring board, comprising the steps of:
preparing a resin baseplate having a base wiring pattern on both sides;
forming a first insulating layer on both sides of the resin baseplate to cover the base wiring pattern;
forming a throughhole penetrating the resin baseplate having the first insulating layers on both sides thereof;
forming a conductive layer which covers the first insulating layer, for both sides of the resin baseplate, and coats a side wall of the throughhole;
filling a space within the throughhole with a filler material having a thermal coefficient substantially equal to that of the resin baseplate;
flattening, for both sides of the resin baseplate, an end of the filler material protruding from the throughhole and a free surface of the conductive layer so that the end of the filler material and the free surface of the conductive layer are flush with each other;
etching, for both sides of the resin baseplate, the conductive layer to form a second wiring pattern on the first insulating layer;
forming, for both sides of the resin baseplate, a second insulating layer which covers the second wiring pattern; and
forming, for both sides of the resin baseplate, a third wiring pattern on the second insulating layer.

6. A process of producing a multilayer wiring board, comprising the steps of:
preparing a resin baseplate having a first wiring pattern on both sides;
forming a first insulating layer on both sides of the resin baseplate to cover the first wiring pattern;
forming a throughhole penetrating the resin baseplate having the insulating layers on both sides thereof;
forming a first conductive layer which covers the first insulating layer, for both sides of the resin baseplate, and coats a side wall of the throughhole;
filling a space within the throughhole with a filler material having a thermal coefficient substantially equal to that of the resin baseplate;
flattening, for both sides of the resin baseplate, an end of the filler material protruding from the throughhole and a free surface of the first conductive layer so that the end of the filler material and the free surface of the first conductive layer are flush with each other;
forming, for both sides of the resin baseplate, a second conductive layer on the first conductive layer and the end of the filler material, the first and second conductive layers forming a single conductive layer;
etching, for both sides of the resin baseplate, the single conductive layer to form a second wiring pattern on the first insulating layer;
forming, for both sides of the resin baseplate, a second insulating layer which covers the second wiring pattern; and
forming, for both sides of the resin baseplate, a third wiring pattern on the second insulating layer.

7. A process according to claim 6, wherein the step of flattening is modified so that the end of the filler material is concaved and the free surface of the first conductive layer is flattened.

8. A process according to any one of claims 5, 6 and 7, wherein the first and second insulating layers are formed by laminating an insulating film.
